Europäisches Patentamt

European Patent Office

Office européen des brevets

(19)

(11) Veröffentlichungsnummer : **0 157 110
B1**

(12) EUROPÄISCHE PATENTSCHRIFT

(45) Veröffentlichungstag der Patentschrift :
23.11.89

(51) Int. Cl.⁴ : **G 01 R 19/145**

(21) Anmeldenummer : 85101104.9

(22) Anmeldetag : 02.02.85

(54) Schaltung zur Übertragung eines Binärsignales.

(30) Priorität : 25.02.84 DE 8406144 U

(43) Veröffentlichungstag der Anmeldung :
09.10.85 Patentblatt 85/41

(45) Bekanntmachung des Hinweises auf die Patenterteilung : 23.11.89 Patentblatt 89/47

(84) Benannte Vertragsstaaten :
AT BE CH DE FR GB IT LI LU NL SE

(56) Entgegenhaltungen :
DE–A– 2 061 588
US–A– 4 063 121
US–A– 4 197 471
INSTRUMENTS AND EXPERIMENTAL TECHNIQUES,
Band 19, Nr. 2, Punkt 1, März/April 1976, Seiten 393-
396, New York, US; V.P. D'YAKONOV: "Amplitude
limiters and threshold devices based on integrated
microcircuits

(73) Patentinhaber : **Joh. Vaillant GmbH u. Co.
Berghauser Strasse 40 Postfach 10 10 20
D-5630 Remscheid 1 (DE)
DE IT LU SE
COFRABEL N.V.
15, rue Golden Hope straat
B-1620 Drogenbos (BE)
BE
VAILLANT S.A.R.L
4, Rue des Oliviers Orly-Sénia 326
F-94537 Rungis Cedex (FR)
FR
VAILLANT Ges.m.b.H
Forchheimergasse 7 Postfach 56
A-1233 Wien (AT)
AT
Vaillant Ltd.
Vaillant House Medway City Estate Trident Close
Rochester Kent ME2 4EZ (GB)
GB
SCHONEWELLE B.V.
Ellermanstraat 17
NL-1099 BX Amsterdam (NL)
NL
Vaillant GmbH
Riedstrasse 8
CH-8953 Dietikon 1 (CH)
CH LI**

(72) Erfinder : **Hangauer, Wilfried, Dr.
Heidenstrasse 15
D-5609 Hückeswagen (DE)**
Erfinder : **Kind, Reiner
Marktstrasse 29
D-5609 Hückeswagen (DE)**

(74) Vertreter : **Heim, Johann-Ludwig**
**c/o Joh. Vaillant GmbH u. Co Postfach 10 10 20**
**Berghauser Strasse 40**
**D-5630 Remscheid 1 (DE)**

**Beschreibung**

Die vorliegende Erfindung bezieht sich auf eine Schaltung zur Übertragung eines Binärsignales gemäß dem Oberbegriff des unabhängigen Anspruchs.

Eine solche Schaltung ist bekanntgeworden aus der US-A-4 197 471. Hier ist ein Fototransistor vorgesehen, dessen Basis und Emitter über eine Parallelschaltung eines Kondensators und eines Widerstandes unmittelbar verbunden sind. Emitter und Kollektor bilden mit dem RC-Glied einen Zweipol, der mit einer Auswerterschaltung seinerseits verbunden ist.

Aus dem Aufsatz von V.P. D'YAKONOV « Amplitude limiters and threshold devices based on integrated microcircuits », erschienen in INSTRUMENTS AND EXPERIMENTAL TECHHIQUES 19 (1976), 3/4, Seiten 393-396, ist die Beschaltung eines steuerbaren Transistors bekannt, wobei die Basis mit einem Eingangswiderstand, der Emitter mit einem Massewiderstand und der Kollektor mit dem Emitter über diese Kettenschaltung und zwei invertierende spannungsbegrenzende Verstärker und einen Widerstand verbunden sind. Der Ausgang ist hinter dem zweiten Verstärker abgenommen.

Aus der DE-A-2 061 588 ist eine Opto-Koppler-Schaltung bekanntgeworden, bei der ein Fototransistor Verwendung findet, der mit einer der Versorgungsspannungen über einen Widerstand mit dem anderen Pol der Versorgungsspannung hingegen unmittelbar verbunden ist. Von der Basis zum Kollektor ist ein Kondensator geschaltet.

Schaltungen gemäß dem Oberbegriff des Anspruchs 1, finden insbesondere dann Verwendung, wenn eine galvanische Trennung zwischen einer Ausgangimpulsspannung mit Impulsen beiderlei Polarität und einer davon abgeleiteten Spannung bestehen soll. Insbesondere ist das Anwendungsgebiet der erfindungsgemäßen Schaltung die Ableitung einer Gleichausgangsspannung von einer Netzwechselspannung von insbesondere 220 V und 50 Hz.

Hierbei besteht die Aufgabe, die Gleichausgangsspannung dann anstehen zu lassen, wenn die Eingangsspannung anliegt, und zwar auch unter Offenhaltung einer sehr großen Spannungstoleranzschwelle, wobei die verwendete Schaltung Schmitt-Trigger-Verhalten aufweisen soll.

Die Lösung dieser Aufgabe besteht in den Merkmalen des Hauptanspruchs.

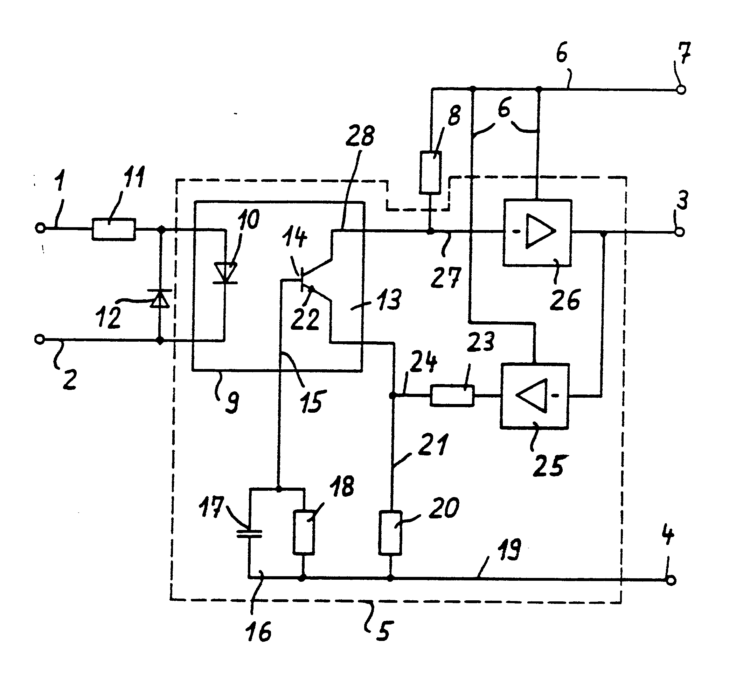

Weitere Ausgestaltungen und besonders vorteilhafte Weiterbildungen der Erfindung sind Gegenstand des Unteranspruchs beziehungsweise gehen aus der nachfolgenden Beschreibung hervor, die ein Ausführungsbeispiel der Erfindung anhand der Figur der Zeichnung näher erläutert.

Die Zeichnung stellt eine elektrische Schaltung dar. Die Schaltung ist nach Art eines Vierpols aufgebaut und weist einen Eingang 1 sowie 2 auf, an denen vorzugsweise eine Netzwechselspannung von 50 Hz anschließt. Weiterhin besitzt der Vierpol Ausgangsklemmen 3 und 4, die von den Eingangsklemmen galvanisch getrennt werden sollen. Der Vierpol ist mit 5 bezeichnet. Er wird über eine Leitung 6 mit einer Klemme 7 unter Zwischenschaltung eines Speisespannungswiderstandes 8 mit einer speisenden Betriebsspannung versorgt. Die Leitung 6 setzt Verzweigungen zur Spannungsversorgung von Verstärkerstufen. Hauptelement des Vierpols ist ein Opto-Koppler 9, dessen primäres Bauteil eine Leuchtdiode 10 ist, die mit ihren beiden Polen unter Zwischenschaltung eines Widerstandes 11 an die beiden Klemmen 1 und 2 angeschlossen ist. Parallel zu der Diode 10 liegt eine weitere zu ihr antiparallel geschaltete Diode 12 zum Unterdrücken von Spannungsimpulsen der anderen Polarität.

Sekundärseitig besteht der Opto-Koppler aus einem Fototransistor 13, dessen Basis 14 über eine Leitung 15 aus dem Gehäuse des Opto-Kopplers herausgeführt ist und die mit einem RC-Glied 16 beschaltet ist. Dieses besteht aus der Parallelschaltung eines Kondensators 17 mit einem ohmschen Widerstand 18, die auf der der Leitung 15 abgewandten Seite mit einer Leitung 19 verbunden ist, die ihrerseits zur Klemme 4 führt. Von der Leitung 19 zweigt eine mit einem Widerstand 20 versehene Leitung 21 ab, die mit dem Emitter 22 des Fototransistors verbunden ist.

Von der Leitung 21 zweigt zwischen dem Emitter 22 und dem Widerstand 20 eine mit einem Widerstand 23 versehene Leitung 24 ab, die über eine invertierende Verstärkerstufe 25 zur Klemme 3 geführt ist. Die Klemme 3 ist andererseits parallel zu dem eben beschriebenen Weg gleichfalls über eine invertierende weitere Verstärkerstufe 26 mit einer Leitung 27 verbunden, die ihrerseits unmittelbar zum Kollektor 28 des Fototransistors 13 führt. An die Leitung 27 ist der Arbeitswiderstand 8 angeschlossen.

Die Funktion der eben beschriebenen Schaltung ist folgende :

Betriebsgleichspannung liegt zwischen den Klemmen 7 und 4, an den Eingangsklemmen 1 und 2 liegt keine Impulsspannung an. Damit ist die Leuchtdiode 10 dunkel, der Fototransistor 13 gesperrt. Der Kondensator 17 ist entladen, und zwar über den Widerstand 18. Zwischen den Klemmen 3 und 4 ist keine Spannung, da über den Arbeitswiderstand 8 kein Strom fließt und die beiden Verstärkerstufen 25 und 26 invertieren. Damit liegt am Ausgang des Verstärkers 25 ein Spannungssignal gegenüber der Klemme 4, so daß der Emitter 22 des Fototransistors 13 auf einem Spannungsniveau positiv gegenüber der Basis 14 liegt.

Wird nunmehr an die Klemmen 1 und 2 eine entweder sinusförmige oder rechteckförmige Impulsspannung gelegt, so werden die Impulse der einen Polarität durch die Diode 14 von der Leuchtdiode 10 ferngehalten, während die Leuchtdiode gemäß der Impulsfolge der Impulse der anderen Polarität leuchtet. Dieses Leuchten wird innerhalb

des Opto-Kopplers 9 auf den Fototransistor 13 übertragen, so daß die Kollektorbasisstrecke des Fototransistors in der Folge dieser Lichtimpulse leitend wird. Dies führt zu einem Ladestrom für den Kondensator 17. Damit stellt sich auf der Leitung 15, das heißt an der Basis des Fototransistors, ein mittlerer Spannungswert ein, der dem zeitlichen Mittelwert des Fotostroms entspricht. Übersteigt dieser mittlere Spannungswert den Spannungswert, der am Emitter 22 des Fototransistors ansteht, um eine Diodenflußspannung, so wird der Fototransistor leitend, wodurch der Kollektorstrom erheblich ansteigt. Damit entsteht an dem Arbeitswiderstand 8 ein Spannungsabfall, der über die beiden Verstärkerstufen 25 und 26 mit gleichem Vorzeichen auf den Spannungsteiler, bestehend aus den Widerständen 23 und 20, übertragen wird und damit als Mitkopplung auf den Fototransistor 13 wirkt. Damit wird das Kippen des Fototransistors beschleunigt. Dieses Kippen des Fototransistors führt aber zu einem entsprechenden Spannungssignal auf der Klemme 3, so daß zwischen Klemmen 3 und 4 nunmehr eine Ausgangsspannung anliegt. Diese Ausgangsspannung bleibt so lange bestehen, wie über die Fotodiode 10 Impulse übertragen werden. Die Ausgangsspannung erlischt, wenn infolge der Entladung des Kondensators 17 über den Parallelwiderstand 18 die Basisspannung des Fototransistors so weit abgesenkt wird, daß dieser wieder in den Sperrzustand zurückkehrt. Der Mitkoppeleffekt des Abschaltens des Transistors 13 ist über den Arbeitswiderstand 8 in Verbindung mit den beiden Verstärkerstufen 25 und 26 auch beim Sperren gegeben.

Die erfindungsgemäße Schaltung könnte soweit variiert werden, als daß der Kondensator 17 auch zwischen Kollektor und Basis des Fototransistors 13 gelegt werden kann. Die beiden Verstärkerstufen 25 und 26 können als Einzeltransistoren wie auch als Operationsverstärker ausgebildet sein. Will man ein Ausgangsspannungssignal an den Klemmen 3 und 4 haben, das Null wird, wenn eine Impulsfolge am Eingang 1 und 2 anliegt, würde man die Ausgangsklemme 3 an den Ausgang der Verstärkerstufe 25 legen. Hiermit ist eine Invertierung des logischen Signals möglich.

## Patentansprüche

1. Schaltung zur Übertragung eines Binärsignals über einen beschalteten Vierpol, an dem eine Impulsspannung am Eingang, eine Gleichspannung bei Vorhandensein der Impulsspannung am Ausgang ansteht, wobei der Vierpol (5) einen Opto-Koppler (9) enthält, dessen aktives Element ausgangsseitig ein Fototransistor (13) ist, dessen Basis (14) mit einem Kondensator (17) verbunden ist und über einen Widerstand (18) mit einer ersten Ausgangsklemme (4) des Vierpols (5), die einem ersten Versorgungsspannungsanschluß entspricht, oder mit dem Emitter (22) des Fototransistors (13) verbunden ist, dadurch gekennzeichnet, daß der Kondensator (17) an seinem der Basis (14) des Fototransistors abgewandten Ende mit dem Kollektor (28) des Fototransistors (13) oder mit der ersten Ausgangsklemme (4) verbunden ist und daß Emitter und Kollektor (28) des Fototransistors über wenigstens zwei invertierende und in die Serie geschaltete Verstärkerstufen (25, 26) verbunden sind und die zweite Ausgangsklemme (3) des Vierpols den Ausgang einer der Verstärkerstufen (25, 26) bildet, wobei wenigstens eine der Verstärkerstufen ausgangsspannungsbegrenzende Eigenschaften besitzt.

2. Schaltung nach Anspruch 1, dadurch gekennzeichnet, daß der Emitter und der Kollektor des Fototransistors (13) über je einen Widerstand (8, 20) mit der ersten Ausgangsklemme (4) beziehungsweise mit einem zweiten Versorgungsspannungsanschluß (7) verbunden sind.

## Claims

1. A circuit arrangement for transmitting a binary signal via a wired four-terminal network, to which pulsed voltage is applied at its input and which presents at its output a d.c. voltage when the pulsed voltage is applied to its input, wherein the four-terminal network (5) comprises an optoelectronic coupler (9), the active element of which on the output side is a phototransistor (13), the base (14) of which is connected to a capacitor (17) and is connected by a resistor (18) to a first output terminal (4) of the four-terminal network (5), which first output terminal corresponds to a supply voltage terminal, or to the emitter (22) of the phototransistor (13), characterized in that that end of the capacitor (17) which is remote from the base (14) of the phototransistor is connected to the collector (28) of the phototransistor (13) or to the first output terminal (4), the emitter and collector (28) of the phototransistor are connected by at least tow series-connected inverting amplifier stages (25, 26), the second output terminal (3) of the four-terminal network constitutes the output of one of the amplifier stages (25, 26) and at least one of the amplifier stages has properties which limit the output coltage.

2. A circuit arrangement according to claim 1, characterized in that the emitter and the collector of the phototransistor (13) are respectively connected by respective resistors (8, 20) to the first output terminal (4) and a second supply voltage terminal (7).

## Revendications

1. Montage pour la transmission d'un signal binaire par l'intermédiaire d'un quadripôle à l'entrée duquel est appliquée une tension impulsionnelle, et à sa sortie, une tension continue en présence de la tension impulsionnelle, le quadripôle (5) comprenant un optocoupleur (9) dont l'élément actif du côté sortie est un phototransistor (13) dont la base (14) est reliée à un condensateur (17) et, par l'intermédiaire d'une résistance (18), à une première borne de sortie (4) du quadripôle (5), laquelle correspond à un premier branchement de tension d'alimentation, ou à l'émetteur (22) du phototransistor (13), caractérisé par le fait que le condensateur (17) est relié par son extrémité ne regardant pas la base (14) du phototransistor au collecteur (28) du phototransistor (13) ou à la première borne de sortie (4), et que l'émetteur et le collecteur (28) du phototransistor sont reliés par au moins deux étages amplificateurs (25, 26) inverseurs et montés dans la série, et que la deuxième borne de sortie (3) du quadripôle forme la sortie de l'un des étages amplificateurs (25, 26), au moins l'un de ces étages ayant des caractéristiques pour limiter la tension de sortie.

2. Montage suivant la revendication 1, caractérisé par le fait que l'émetteur et le collecteur du phototransistor (13) sont reliés respectivement par une résistance (8, 20) à la première borne de sortie (4) ou à un deuxième branchement de tension d'alimentation (7).